# EUROPEAN PATENT APPLICATION

(11) **EP 4 770 341 A1**
(43) Date of publication of application: **01.07.2026**
(21) Application number: 25227317.2
(22) Date of filing: 27.12.2025
(51) Int. Cl.: H10F 19/35, H10F 19/75, H10F 19/31

(54) **PHOTOVOLTAIC ELEMENT HAVING OPTOELECTRONIC CELLS COMPRISING A CURRENT-CONTRIBUTING AREA AND A NON-CURRENT-CONTRIBUTING AREA**

(30) Priority: 27.12.2024 EP 24223356
(71) Applicant: Heliatek GmbH, 01139 Dresden (DE)
(72) Inventor: Widmer, Johannes, 01139 Dresden (DE); Greifzu, Georg, 01139 Dresden (DE); Berger, Ulf, 01139 Dresden (DE); Fischer, Dustin, 01139 Dresden (DE); Fischer, Simon, 01139 Dresden (DE)

(57) **Abstract**

The invention relates to a photovoltaic element (100) having at least two optoelectronic cells (1) being connected in series, each optoelectronic cell (1) having a stack (10) comprising a base electrode (11), a top electrode (12), a photoactive layer (13) arranged between the base electrode (11) and the top electrode (12), and P1 structures which electrically separate the base electrode (11), P2 structures which electrically separate the photoactive layer (13), and P3 which electrically separate the top electrode (12). Each optoelectronic cell (1) comprises a current-contributing area (I) and at least one non-current-contributing area (II) which share the same stack (10), wherein the at least one non-current-contributing area (II) is arranged within the current-contributing area (I) extending to a following optoelectronic cell (1) in the direction of current flow and delimited from the current-contributing area (I) by separating structures, wherein the current-contributing area (I) and the at least one non-current-contributing area (II) of the optoelectronic cell (1) are electrically connected antiparallel to each other, wherein the stack (10) of each optoelectronic cell (1) is structured by P1 structures between the current-contributing area (I) and the at least one non-current-contributing area (II), and the base electrode (11) of the at least one non-current-contributing area (II) is electrically connected to the top electrode (12) of the current-contributing area (I), wherein the at least one non-current-contributing area (II) is delimited by P3 structures from the current-contributing area (I) of the optoelectronic cell (1) and the at least one non-current-contributing area (II) of the following optoelectronic cell (1) in the direction of current flow forming three edges (15), and wherein additional P2 structures are formed within the at least one non-current-contributing area (II) in parallel at least partly along each of the three edges (15) between the P3 structures and the P1 structures.

## Description

The invention relates to a photovoltaic element for converting light into electrical energy with improved efficiency and service life in the case of partial shading. The photovoltaic element having at least two optoelectronic cells being connected in series, each optoelectronic cell comprises a current-contributing area I and at least one non-current-contributing area II, wherein the at least one non-current-contributing area II and the current-contributing area I of the optoelectronic cell share the same stack, wherein the at least one non-current-contributing area II is arranged within the current-contributing area I and is delimited from the current-contributing area I by separating structures, and wherein the current-contributing area I and the at least one non-current-contributing area II of the optoelectronic cell are electrically connected antiparallel to each other.

Photovoltaic elements, also called solar cells, that are integrated into or attached to a building structure can be partly or fully shaded. Photovoltaic elements or optoelectronic cells thereof which are connected in series are not always shaded to the same extent but are still partly exposed to sunlight. A problem occurring with serially interconnected optoelectronic cells when one or more individual optoelectronic cells are at least partly shaded is that the shaded optoelectronic cells form reverse-biased diodes with respect to the unshaded or less shaded optoelectronic cells connected in series. The shaded or partly shaded optoelectronic cells therefore impede the flow of photogenerated current, which has a negative effect on efficiency. In addition, there is a risk of concentrated current flow in the shaded optoelectronic cells through regions exhibiting local defects, which can lead to local overheating and eventually irreversible degradation of the optoelectronic cells, resulting in a loss of efficiency of the photovoltaic element comprising said optoelectronic cells.

Methods known from the prior art for circumventing the problem of partial shading use bypass diodes to ensure the flow of current of optoelectronic cells connected in series and to avoid damage to the partly shaded optoelectronic cells. In the case of a shaded or defective optoelectronic cell, the power loss and/or damage is reduced or avoided by connecting a bypass diode in parallel to the optoelectronic cells. In case an optoelectronic cell is shaded or at least partly shaded, it generates no current flow or a lower current flow, and the current generated by the optoelectronic cells connected in series upstream in the direction of current flow cannot be conducted and blocks or damages the at least partly shaded optoelectronic cell. In such a case, the bypass diode can take over the conduction of the generated current from optoelectronic cells connected upstream to optoelectronic cells connected downstream in direction of current flow, thereby preventing damage to the shaded optoelectronic cell. However, such a solution is very costly and requires additional steps in manufacturing and/or integration of additional external components.

US 2015/0349164 A1 discloses an integrated bypass diode in a solar cell, wherein the bypass diode and the solar cell comprise different regions alongside one another on the substrate and are completely electrically isolated by trenches, and the contacting is only affected subsequently.

Module level protection can be implemented at the junction box of each module shortcutting the whole module by means of a protective device in case of partial shading.

US 4460232 A discloses a junction box for mounting on a photovoltaic solar module providing means for connecting plug members to two discrete bus bars in said solar module and comprising a diode.

It is therefore an object of the present invention to provide an photovoltaic element comprising optoelectronic cells connected in series in which the disadvantages mentioned do not occur, in particular, no failure of the complete photovoltaic element occurs in case of a single defective or non-working optoelectronic cell, e.g. in the event of partial shading, wherein in particular the manufacture of the photovoltaic element shall be cost-effective and can be integrated into the photovoltaic element manufacturing process without additional components.

However, when bypass areas are integrated into a stack by laser-structuring, and current flows through it in the event of shading such areas, especially at edge areas, heat up particularly strongly. These areas represent a serious weak point that can lead to degradation of the layer system and damage the bypass areas, and thus also their functionality. A particularly vulnerable point or area is the power coupling, especially near a P2/P3 structure and connection points between the bypass areas and the areas intended for generating photovoltaic power. At this points or areas, in particular edges, of the bypass area get hot, and degraded rapidly. As a result, the bypass area could be made much larger which, however, is undesirable due to the resulting loss of photoactive surface area.

It is therefore also an object of the present invention to improve electricity management and heat management in bypass areas.

The object is achieved by the subject of the independent claims. Advantageous configurations are apparent from the dependent claims.

The object of the present invention is in particular solved by a photovoltaic element having at least two optoelectronic cells, the at least two optoelectronic cells being connected in series, each optoelectronic cell having a stack comprising a base electrode, a top electrode, a photoactive layer arranged between the base electrode and the top electrode, structures of a first type (P1 structures) which electrically separate the base electrode, structures of a second type (P2 structures) which electrically separate the photoactive layer, and structures of a third type (P3 structures) which electrically separate the top electrode, wherein each optoelectronic cell comprises a current-contributing area I and at least one non-current-contributing area II which share the same stack, wherein the at least one non-current-contributing area II is arranged within the current-contributing area I extending to a following optoelectronic cell in the direction of current flow and delimited from the current-contributing area I by separating structures, wherein the current-contributing area I and the at least one non-current-contributing area II of the optoelectronic cell are electrically connected antiparallel to each other, wherein the stack of each optoelectronic cell is structured by P1 structures between the current-contributing area I and the at least one non-current-contributing area II, and the base electrode of the at least one non-current-contributing area II is electrically connected to the top electrode of the current-contributing area I, wherein the at least one non-current-contributing area II is delimited by P3 structures from the current-contributing area I of the optoelectronic cell and the at least one non-current-contributing area II of the following optoelectronic cell in the direction of current flow forming three edges, and wherein additional P2 structures are formed within the at least one non-current-contributing area II in parallel at least partly along each of the three edges between the P3 structures and the P1 structures.

According to the invention, it is preferably provided that the photovoltaic element comprises a plurality of optoelectronic cells, wherein the optoelectronic cells of the photovoltaic element are arranged next to each other and connected in series. Preferably, each optoelectronic cell has its own base electrode and top electrode, in particular electrically connecting the base electrode of one optoelectronic cell to the top electrode of the following optoelectronic cell in the direction of current flow. Due to the at least two optoelectronic cells being connected in series a current flow through the optoelectronic cells passes through the optoelectronic cells one after another. Thus, the current flows from one optoelectronic cell to an immediately neighboring optoelectronic cell. Optoelectronic cells that are located directly next to each other are considered to be neighboring optoelectronic cells.

According to the present invention, the current flow under illumination condition, a so-called power-generating mode, is different from the current flow under shaded or partly shaded condition. Under illumination condition, in particular, the current flows via the current-contributing area I, in particular from the top electrode of the non-current-contributing area II via the P2 structure of the photoactive layer of the current-contributing area I to the base electrode of the current-contributing area I and via the base electrode of the current-contributing area I to a neighboring optoelectronic cell in the direction of current flow. In the event the photovoltaic element is shaded or at least partly shaded, in particular the current flows via the non-current-contributing area II, in particular from the top electrode of the non-current-contributing area II via the photoactive layer of the non-current-contributing area II and the base electrode of the non-current-contributing area II to the top electrode of a non-current-contributing area II of an immediately neighboring, which is a following, optoelectronic cell in the direction of current flow.

In the context of the present invention, a separating structure of a first type (P1) electrically separates the base electrode, a separating structure of a second type (P2) electrically separates the photoactive layer, and a separating structure of a third type (P3) electrically separates the top electrode.

According to the present invention, the additional P2 structures of the non-current-contributing area II are electrically connecting the base electrode and top electrode in the non-current-contributing region of the optoelectronic cell. This in particular allows that a current generated by illumination flows in a reverse direction with respect to the current generated in the current-contributing area I due to the stack being structured by separating structures in such a way that the non-current-contributing area II is electrically connected anti-parallel with respect to the current-contributing area I.

A photoactive layer is in particular understood to be a layer which is capable of converting light incident on the photoactive layer into electric current. The photoactive layer preferably comprises a plurality of sublayers, in particular absorbing light of a distinct wavelength range, electron transport layers or hole transport layers.

A current-contributing area I of an optoelectronic cell is in particular understood to be a part of the area of the optoelectronic cell in which an electric potential respective an electric current is generated when light is incident on the optoelectronic cell and contributes in an additive way to the total voltage of the cells connected in series.

A non-current-contributing area II of an optoelectronic cell is in particular understood to be a part of the area of an optoelectronic cell in which no electric potential respective no electric current is generated when light is incident on the optoelectronic cell or, alternatively, in which an electric potential respective electric current of reverse polarity with respect to the electric potential respective electric current generated in the current-contributing area I of the optoelectronic cell is generated when light is incident on the optoelectronic cell, thus, not contributing to the total voltage of the cells connected in series. Thus, the non-current-contributing area II of an optoelectronic cell does not make a constructive contribution to the electric current generated by the optoelectronic cell when light is incident on the optoelectronic cell.

For the purposes of this application it is in particular understood that a small area or a narrow strip of the non-current-contributing area II remains between the three edges of the non-current-contributing area II and the current-contributing area I of the same optoelectronic cell and/or the non-current-contributing area II of a following optoelectronic cell in the direction of current flow as a non-functional area, which non-functional area neither contributes to the generation of current nor functions as a bypass area, in particular bypass-diode. This is in particular on the one hand for manufacturing reasons, and on the other hand to have a buffer zone between the bypass area and the current-contributing area I, namely the area contributing to power generation.

In a preferred embodiment, the at least one non-current-contributing area II of the optoelectronic cell is located immediately next to the at least one non-current-contributing area II of a neighboring optoelectronic cell.

The photovoltaic element according to the invention has advantages over the prior art. Advantageously, the photovoltaic element enables current generated in neighboring optoelectronic cells to pass through the optoelectronic cell in case of partial or complete shading of said optoelectronic cell. In particular, integrating non-current-contributing areas II into the stack of the optoelectronic cell by structuring the stack using separating structures to introduce non-current-contributing areas II within the current-contributing area I in terms of process engineering and in terms of manufacturing is a simple procedure, and, moreover, cost-effective. Advantageously, in the reverse direction of current flow, the current of optoelectronic cells connected in series is conducted through the non-current-contributing area II with low resistance to minimize energy losses and protect the current-contributing area I from damage. Advantageously, by using improved P2 structures or improved P2 structures and P1 structures of the present invention, the current flow and, thus, the heating is distributed over a longer edge length of the bypass area, so that excessive heating of the bypass areas, especially the edges, is avoided, as a smaller size of the bypass area allows for the same current flow in the long term. In this regard, the improved P2 structures allow distribution of current flow over longer P2/P3 edges, and improved P1 structures allow to separate remaining P3 structures from the P3 structures of the non-current-contributing area II, which functions as a bypass area, and prevent from heating and damage by current flow in the remaining P3 structures. Advantageously, no additional components, neither arranged external or internal of the photovoltaic element, for protecting individual optoelectronic cells are required. Advantageously, the current generated in the current-contributing area I of the optoelectronic cell in case of working as intended under illumination does not pass through the non-current-contributing area II, in particular, since the non-current-contributing area II and the current-contributing area I share the same stack and are electrically antiparallel connected to each other. Advantageously, the electricity management and the heat management in the non-current-contributing areas II is improved, in particular, overheating of individual points or areas in the non-current-contributing area II, especially at the P3 structures of the three edges, is reduced or prevented. Advantageously, the optoelectronic cells have a very homogeneous optical impression since the current-contributing area I and the non-current-contributing area II share the same stack and do not differ in terms of color.

According to a further development of the invention, it is provided that P1 structures electrically separate the base electrode of the current-contributing area I and of the at least one non-current-contributing area II of the neighboring optoelectronic cells.

In a preferred embodiment P1 structures electrically separate the current-contributing area I and the at least one non-current-contributing area II of an optoelectronic cell from the current-contributing area I and the at least one non-current-contributing area II of neighboring optoelectronic cells. In particular, the base electrode of the at least one non-current-contributing area II of an optoelectronic cell is electrically separated from the base electrode of the current-contributing area I as well as the base electrode of the at least one non-current-contributing area II of a neighboring optoelectronic cell by separating structures.

According to a further development of the invention, it is provided that P1 structures between the current-contributing area I and the at least one non-current-contributing area II of the optoelectronic cell and between neighboring optoelectronic cells, P2 structures between the current-contributing area I of the optoelectronic cell and the current-contributing area I of neighboring optoelectronic cells, and P3 structures between the current-contributing area I and the non-current-contributing area II of the optoelectronic cell and the current-contributing area I of a neighboring optoelectronic cell are formed.

According to a further development of the invention, it is provided the non-current-contributing area II of each optoelectronic cell extends over the entire distance of each optoelectronic cell in transverse direction.

In a preferred embodiment, the three edges and the P1 structure separating the non-current-contributing area II of the optoelectronic cell from the non-current-contributing area of a preceding optoelectronic cell in the direction of current flow form a bypass-area.

In a preferred embodiment, the additional P2 structures are formed within the at least one non-current-contributing area II in parallel at least partly along each of the three edges between the P3 structures and the P1 structures separating the non-current-contributing area II from the current-contributing area I of the same optoelectronic cell and separating the non-current-contributing area II of the optoelectronic cell from the non-current-contributing area II of a neighboring optoelectronic cell. Preferably, the additional P2 structures are formed along the shape of the three edges.

In a preferred embodiment, the three edges of the non-current-contributing area II form a rectangular shape in the main extension plane of the optoelectronic cell.

In a preferred embodiment, the optoelectronic cell has a continuous P3 structures extending along the longitudinal direction of the optoelectronic cell, wherein the P3 structures form a bulge in the at least one non-current-contributing area II in the direction of current flow, preferably the bulge has rectangular shape.

According to a further development of the invention, it is provided that the additional P2 structures along each of the three edges extend along an entire length of the three edges between the P3 structures and the P1 structures of the non-current-contributing area II.

According to a further development of the invention, it is provided that a distance between the additional P2 structures along each of the three edges to the corresponding edge in horizontal direction is in the range of 50 µm to 2 mm, preferably in the range of 100 µm to 1 mm, preferably in the range of 100 µm to 500 µm, or preferably in the range of 100 µm to 300 µm.

According to a further development of the invention, it is provided that the top electrode of the current-contributing area I of an optoelectronic cell is electrically connected to the base electrode of the current-contributing area I of the following optoelectronic cell in the direction of current flow.

A longitudinal direction of the optoelectronic cell is in particular understood to be the direction of the longest extent of the optoelectronic cell in the main extension plane of the optoelectronic cells. A transverse direction of the optoelectronic cell is in particular understood to be the direction perpendicular to the longitudinal direction, in particular in the direction of current flow, whereby in this direction the optoelectronic cells are connected in series.

According to a further development of the invention, it is provided that the top electrode of the at least one non-current-contributing area II is electrically connected to the base electrode of the current-contributing area I of the corresponding optoelectronic cell.

According to a further development of the invention, it is provided that the base electrode of the at least one non-current-contributing area II of the optoelectronic cell is electrically connected to the top electrode of an adjacent current-contributing area I of the same optoelectronic cell, preferably by the top electrode extending into the additional P2 structure.

According to a further development of the invention, it is provided that each optoelectronic cell comprises at least two non-current-contributing areas II, preferably comprises two non-current-contributing areas II in a certain distance to each other extending in transverse direction of the optoelectronic cell. Integrating more than one non-current-contributing area II into the current-contributing area I of the optoelectronic cell is advantageous since the evolution of heat of many non-current-contributing areas II can be dissipated more easily than for a single, maybe larger, non-current-contributing area II.

In a preferred embodiment, each optoelectronic cell comprises several of non-current-contributing areas II, preferably several of non-current-contributing areas II at a certain distance to each other in the longitudinal direction of the optoelectronic cell of the main extension plane of the optoelectronic cells.

In a preferred embodiment, all optoelectronic cells of the photovoltaic element comprise the same number of non-current-contributing areas II. In a preferred embodiment, the certain distance of the non-current-contributing areas II to each other in the longitudinal direction of the optoelectronic cell is the same in all optoelectronic cells.

According to a further development of the invention, it is provided that the P3 structures of the optoelectronic cell are continuously extending along the longitudinal direction of the optoelectronic cell, wherein the P3 structures are separating the current-contributing-area I of the optoelectronic cell from the current-contributing-area I of a preceding optoelectronic cell in the direction of current flow and separating the non-current-contributing area II of the optoelectronic cell from the non-current-contributing area II of the following optoelectronic cell in the direction of current flow.

In a preferred embodiment, the top electrode of the the at least one non-current-contributing area II of an optoelectronic cell is electrically connected to the top electrode of an optoelectronic cell preceding in the direction of current flow.

In a preferred embodiment, the at least one non-current-contributing area II of an optoelectronic cell and the at least one non-current-contributing area II of a preceding optoelectronic cell in the direction of current flow commonly share the top electrode.

According to a further development of the invention, it is provided that the three edges of the P3 structures of the optoelectronic cell are arranged at right angles directly to each other and are arranged at right angles directly to the P3 structures separating the current-contributing-area I of the optoelectronic cell from the current-contributing-area I of a preceding optoelectronic cell in the direction of current flow.

According to a further development of the invention, it is provided that an additional P1 structure is formed in the non-current-contributing area II, preferably parallel to the P1 structures to the preceding optoelectronic cell in the direction of current flow, wherein the additional P1 structure separates the base electrode of the non-current-contributing area II at a region where the three edges of the at least one non-current-contributing area II, in particular the two edges separating from the current-contributing area I of the optoelectronic cell, meet the remaining P3 structures of the optoelectronic cell at a side facing away from the preceding optoelectronic cell in the direction of current flow.

In the context of the present invention, remaining P3 structures are in particular understood to be P3 structures which are not part of the three edges formed by P3 structures in the non-current-contributing area II.

According to a further development of the invention, it is provided that the additional P1 structure is formed at the two edges which separate from the current-contributing area I of the optoelectronic cell at a side of the edges facing the remaining P3 structures. This results in a rectangular shape as a bypass area which is formed in combination with the three edges in the non-current-contributing area II.

In a preferred embodiment, a surface area of the surface in the main extension plane of the at least one non-current-contributing area of the optoelectronic cell is 2% to 20% of the total surface area of the surface in the main extension plane of the optoelectronic cell, preferably 2% to 10%, or preferably 2% to 5%. Thereby, the non-current-contributing area which is covered by a covering layer does not generate electric current when the optoelectronic cell working as intended under illumination.

According to a further development of the invention, it is provided that an extension of the at least one non-current-contributing area II in transverse direction is at least twice as large as in longitudinal direction of the optoelectronic cell, preferably at least three times, or preferably at least four times.

In a preferred embodiment, the photoactive layer is forming a CIS, CIGS, GaAs, or Si cell, a perovskite cell or an organic photovoltaic element (OPV), a so-called organic solar cell. An organic photovoltaic element is understood to mean in particular a photovoltaic element having at least one organic photoactive layer, in particular a polymeric organic photovoltaic element or an organic photovoltaic element based on small molecules. Small molecules are understood to be in particular non-polymeric organic molecules with monodisperse molar masses between 100 and 2000 g/mol, which are present in solid phase under normal pressure (atmospheric pressure of the surrounding atmosphere) and at room temperature.

In a preferred embodiment, the photovoltaic element is a flexible photovoltaic element. A flexible photovoltaic element is understood to mean in particular a photovoltaic element which is bendable and/or extensible in a certain area.

The invention is explained in more detail below with reference to the figures:
Fig. 1 shows a schematic illustration of an embodiment of a photovoltaic element in a 3D-scheme and an exploded drawing;
Fig. 2 shows a schematic illustration of embodiments of a structured optoelectronic cell comprising a current-contributing area I and a non-current-contributing area II of a photovoltaic element in plan view and in cross-sectional view;
Fig. 3 shows a schematic illustration of embodiments of structured serial connected optoelectronic cells each comprising a current-contributing area I and a non-current-contributing area II in plan view and in cross-sectional view; and
Fig. 4 shows a schematic illustration of embodiments of photovoltaic elements comprising optoelectronic cells having several non-current-contributing areas II in plan view.

Identical and functionally identical elements are labelled with the same reference symbols, so that reference is made to the previous description. The proportions in the Figures are not to scale.

### Exemplary embodiments of the invention

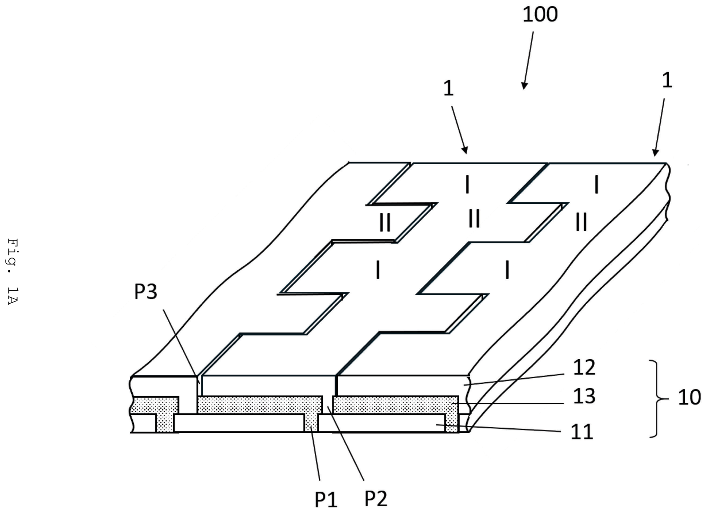

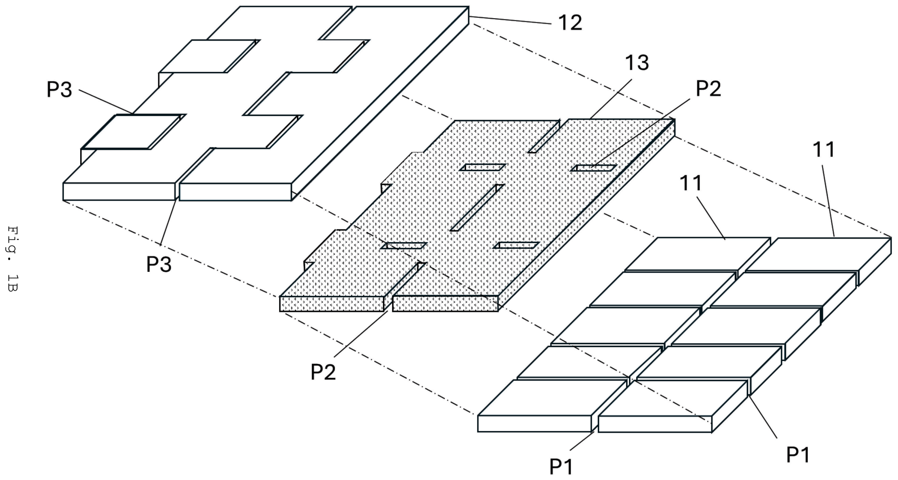

Fig. 1 shows a schematic illustration of an exemplary embodiment of a photovoltaic element 100 in a 3D-scheme (Fig. 1A) and an exploded drawing (Fig. 1B).

The photovoltaic element 100 of Fig. 1A shows a section of two optoelectronic cells 1. The photovoltaic element 100 may comprise a plurality of optoelectronic cells 1 connected in series. The base electrode 11 of optoelectronic cells 1 is structured by separating structures of a first type P1. The photoactive layer 13 of the optoelectronic cells 1 is structured by separating structures of a second type P2. The top electrode 12 of optoelectronic cells 1 is structured by separating structures of a third type P3. In a further embodiment of the invention the photoactive layer 13 is formed by a plurality of sublayers comprising photoactive sublayers, electron transport layers and hole transport layers.

In Fig. 1B, the photovoltaic element 100 of Fig. 1A is shown in an exploded drawing of a section showing the base electrode 11 with structuring of the first type (P1), a section showing the photoactive layer 13 with structuring of the second type (P2), and a section showing the top electrode 12 with structuring of the third type (P3).

In an exemplary embodiment the photovoltaic element 100 is prepared as follows: A layer of metal in a layer thickness of 50 nm is deposited as base electrode 11 onto a transparent substrate (not depicted). Alternatively, a transparent conductive oxide may be used as base electrode 11. The base electrode 11 is structured by laser-structuring to get separating structures of the first type P1. In this example rectangular structures are separated from each other by a separating structure of the first type P1 forming the base electrode layer 11 shown in Fig. 1B. The photoactive layer 13 is deposited onto the base electrode 11. The deposition of the photoactive layer 13 may be performed in several steps in order to grow a plurality of sublayers constituting the photoactive layer 13. Deposition of the photoactive layer 13 may be performed using standard methods like sputtering, chemical vapor deposition (CVD), physical vapor deposition (PVD), or deposition from solution. The photoactive layer 13 is structured using laser-structuring, electron beam structuring, etching using photo masks, etc.

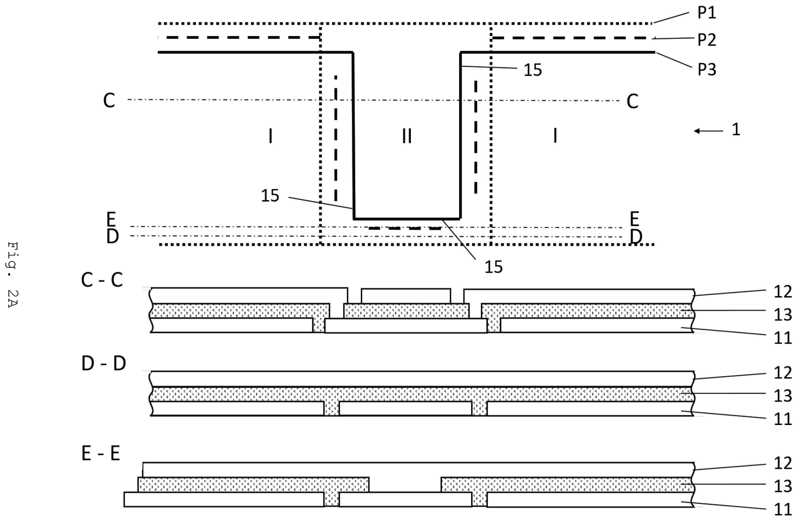

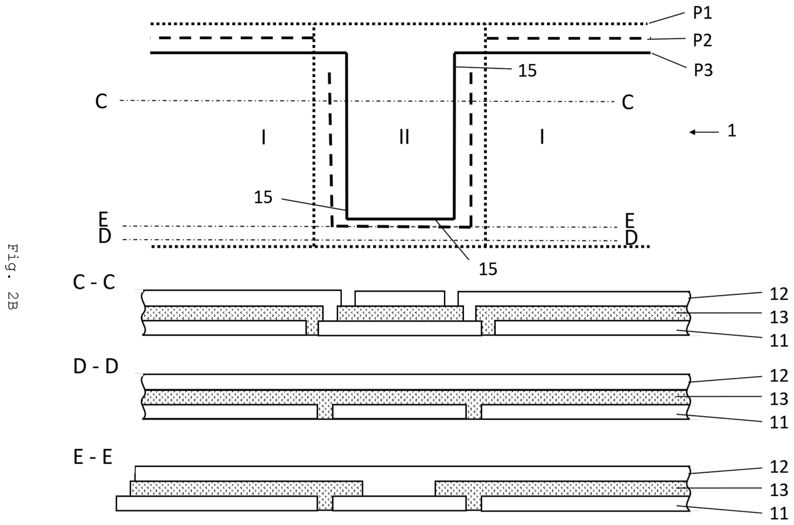

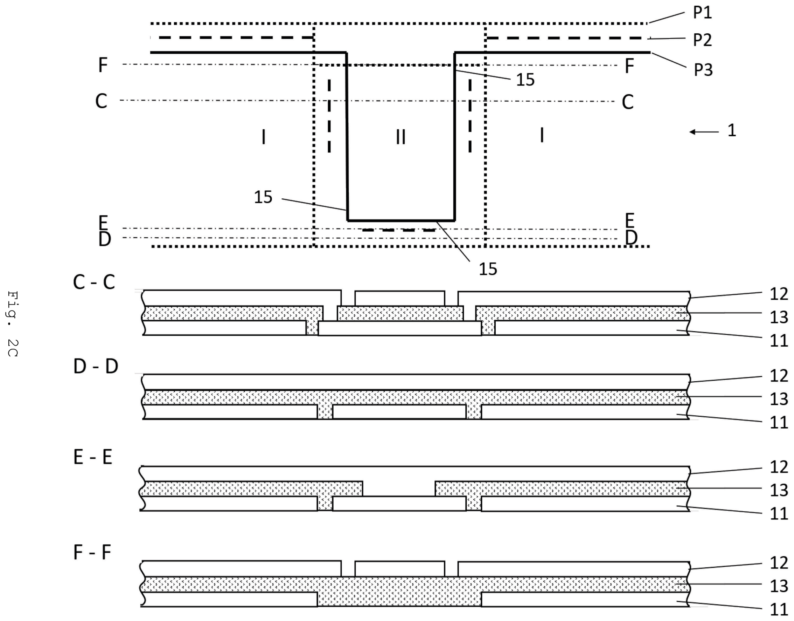

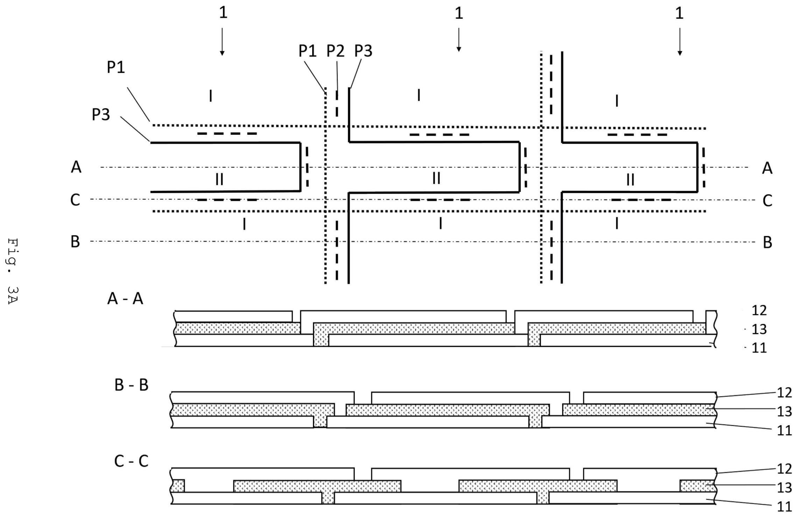

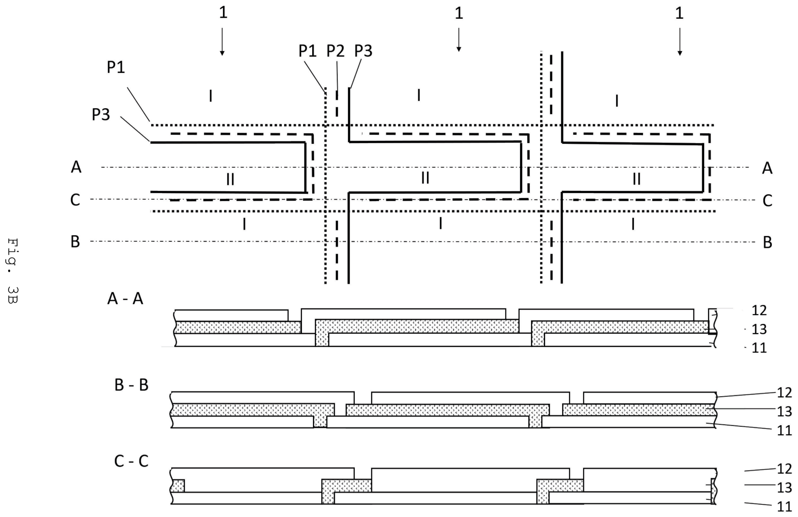

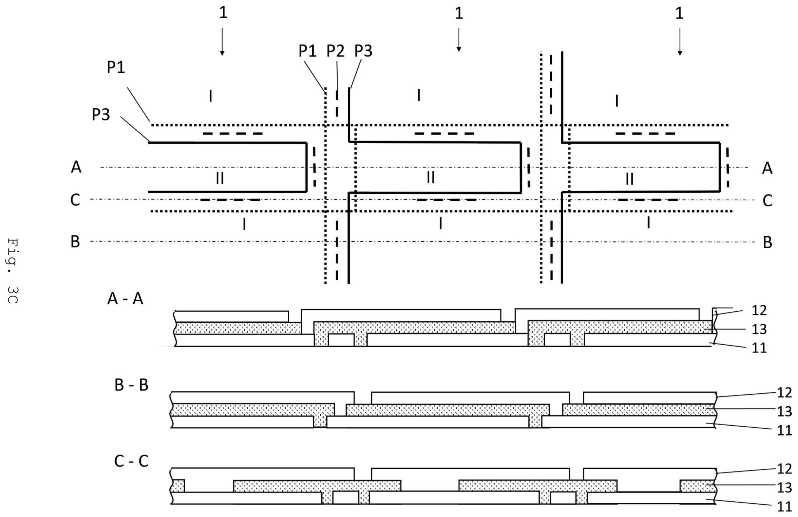

Structuring is performed to create an interrupted line of separating structures of the second type P2 in a longitudinal direction of the optoelectronic cell 1. The line of separating structures of the second type P2 is interrupted at the non-current-contributing area I to be created. Moreover, these separating structures of the second type P2 are created at a distance parallel to the separating structures of the first type P1 running in longitudinal direction of the optoelectronic cell 1. Additional separating structures of the second type P2 are created in the non-current-contributing area II. According to the embodiment shown in Fig. 2, these separating structures of the second type P2 are formed at least partly along separating structures of the third type P3 present within the non-current-contributing area II, in Fig. 2 the separating structures of the second type P2 are in longitudinal direction and in transverse direction of the optoelectronic cell 1. The top electrode 12, e.g. Aluminum, is sputtered or evaporated onto the photoactive layer 13. The separating structures of the second type P2 of the photoactive layer 13 are filled with material of the top electrode 12 in each case creating an electrically conductive connection between top electrode 12 and base electrodes 11. The deposited top electrode 12 is structured by laser structuring, electron beam structuring, etching using photo masks, etc. By structuring a continuous separating structure of the third type P3 extending along the longitudinal direction of the optoelectronic cell 1 is formed, wherein the separating structure of the third type P3 forms a bulge, in particular formed by three edges 15, in the at least one non-current-contributing area II within each optoelectronic cell 1 (see Fig. 2 and Fig. 3). In this embodiment the bulge formed by the three edges 15 has rectangular shape and runs parallel at a distance to the separating structure of the second type P2.

Fig. 2 shows a schematic illustration of embodiments (A to C) of a structured optoelectronic cell 1 comprising a current-contributing area I and a non-current-contributing area II of a photovoltaic element 100 in plan view and in cross-sectional view.

The photovoltaic element 100 having at least two optoelectronic cells 1, the at least two optoelectronic cells 1 being connected in series, each optoelectronic cell 1 having a stack 10 comprising a base electrode 11, a top electrode 12, and a photoactive layer 13 arranged between the base electrode 11 and the top electrode 12. The stack 10 of each optoelectronic cell 1 is structured, by structures of a first type (P1 structures) which electrically separate the base electrode 11, structures of a second type (P2 structures) which electrically separate the photoactive layer 13, and structures of a third type (P3 structures) which electrically separate the top electrode 12. Each optoelectronic cell 1 comprises a current-contributing area I and at least one non-current-contributing area II which share the same stack 10, wherein the at least one non-current-contributing area II is arranged within the current-contributing area I extending to a following optoelectronic cell 1 in the direction of current flow and delimited from the current-contributing area I by separating structures. The current-contributing area I and the at least one non-current-contributing area II of the optoelectronic cell 1 are electrically connected antiparallel to each other, wherein the stack 10 of each optoelectronic cell 1 is structured by P1 structures between the current-contributing area I and the at least one non-current-contributing area II, and the base electrode 11 of the at least one non-current-contributing area II is electrically connected to the top electrode 12 of the current-contributing area I. The at least one non-current-contributing area II is delimited by P3 structures from the current-contributing area I of the optoelectronic cell 1 and the at least one non-current-contributing area II of the following optoelectronic cell 1 in the direction of current flow forming three edges 15. Additional P2 structures are formed within the at least one non-current-contributing area II in parallel at least partly along each of the three edges 15 between the P3 structures and the P1 structures.

In a further configuration of the invention, P1 structures electrically separate the base electrode 11 of the current-contributing area I and of the at least one non-current-contributing area II of neighboring optoelectronic cells 1.

In a further configuration of the invention, P1 structures between the current-contributing area I and the at least one non-current-contributing area II of the optoelectronic cell 1 and between neighboring optoelectronic cells (1), P2 structures between the current-contributing area I of the optoelectronic cell 1 and the current-contributing area I of neighboring optoelectronic cells 1, and P3 structures between the current-contributing area I and the non-current-contributing area II of the optoelectronic cell 1 and the current-contributing area I of a neighboring optoelectronic cell 1 are formed.

In a further configuration of the invention, the non-current-contributing area II of each optoelectronic cell 1 extends over the entire distance of each optoelectronic cell 1 in transverse direction.

In a further configuration of the invention, a distance between the additional P2 structures along each of the three edges 15 to the corresponding edge 15 in horizontal direction is in the range of 50 µm to 2 mm, preferably in the range of 100 µm to 500 µm.

In a further configuration of the invention, the top electrode 12 of the current-contributing area I of an optoelectronic cell 1 is electrically connected to the base electrode 11 of the current-contributing area I of the following optoelectronic cell 1 in the direction of current flow.

In a further configuration of the invention, the top electrode 12 of the at least one non-current-contributing area II is electrically connected to the base electrode 11 of the current-contributing area I of the corresponding optoelectronic cell 1.

In a further configuration of the invention, the base electrode 11 of the at least one non-current-contributing area II of the optoelectronic cell 1 is electrically connected to the top electrode 12 of an adjacent current-contributing area I of the same optoelectronic cell 1.

In a further configuration of the invention, the P3 structures of the optoelectronic cell 1 are continuously extending along the longitudinal direction of the optoelectronic cell 1, wherein the P3 structures are separating the current-contributing-area I of the optoelectronic cell 1 from the current-contributing-area I of a preceding optoelectronic cell 1 in the direction of current flow and separating the non-current-contributing area II of the optoelectronic cell 1 from the non-current-contributing area II of the following optoelectronic cell 1 in the direction of current flow.

In a further configuration of the invention, the three edges 15 of the P3 scribes of the optoelectronic cell 1 are arranged at right angles directly to each other and are arranged at right angles directly to the P3 structures separating the current-contributing-area I of the optoelectronic cell 1 from the current-contributing-area I of a preceding optoelectronic cell 1 in the direction of current flow.

In a further configuration of the invention, an extension of the at least one non-current-contributing area II in transverse direction is at least twice as large as in longitudinal direction of the optoelectronic cell 1, preferably at least three times, or preferably at least four times.

The embodiment shown in Fig. 2B mainly corresponds to that shown in Fig. 2A, wherein in this embodiment the additional P2 structures along each of the three edges 15 extend along an entire length of the three edges between the P3 structures and the P1 structures of the non-current-contributing area II.

The embodiment shown in Fig. 2C mainly corresponds to that shown in Fig. 2A, wherein in this embodiment an additional P1 structure is formed in the non-current-contributing area II, preferably parallel to the P1 structures to the preceding optoelectronic cell 1 in the direction of current flow, wherein the additional P1 structure separates the base electrode 11 of the non-current-contributing area II at a region where the three edges 15 of the at least one non-current-contributing area II, in particular the two edges 15 separating from the current-contributing area I of the optoelectronic cell 1, meet the remaining P3 structures of the optoelectronic cell 1 at a side facing away from the preceding optoelectronic cell 1 in the direction of current flow.

In a further configuration of the invention, the additional P1 structure is formed at the two edges 15 which separate from the current-contributing area I of the optoelectronic cell 1 at a side of the edges facing the remaining P3 structures.

In Fig. 2A, 2B and 2C cross-section C-C demonstrates within one optoelectronic cell 1 the structured stack 10 along the current-contributing area I and the non-current-contributing area II; cross-section D-D demonstrates within one optoelectronic cell 1 the structured stack 10 along the current-contributing area I and an additional P2 structure of the non-current-contributing area II; cross-section E-E demonstrates within one optoelectronic cell 1 the a region between the additional P2 structure and the P1 structure which separates to the following optoelectronic cell 1 in the direction of current flow (not shown).

In Fig. 2A three additional P2 structures are formed within the at least one non-current-contributing area II in parallel partly along each of the three edges 15 between the P3 structures and the P1 structures. The P2 structures being filled with material of the top electrode 12 which electrically connecting the base electrode 11 of the non-current-contributing area I to the top electrode 12 of the current-contributing area I of the same optoelectronic cell 1. In Fig. 2B a configuration of the three additional P2 structures is shown, wherein the P2 structures are formed along each of the three edges 15 and extend along an entire length of the three edges 15 between the P3 structures and the P1 structures of the non-current-contributing area II. In Fig. 2C in addition to Fig. 2C an additional P1 structure is formed in the non-current-contributing area II in parallel to the P1 structures to the preceding optoelectronic cell 1 in the direction of current flow. The additional P1 structure separates the base electrode 11 of the non-current-contributing area II at a region where the two edges 15 of the at least one non-current-contributing area II which are separating from the current-contributing area I of the optoelectronic cell 1 meet the remaining P3 structures of the optoelectronic cell 1 at a side facing away from the preceding optoelectronic cell 1 in the direction of current flow. The additional P1 structure is formed at the two edges 15 which separate from the current-contributing area I of the optoelectronic cell 1 at a side of the edges 15 facing the remaining P3 structures.

The improved additional P2 structures as well as P1 structures contribute to improved electricity and heat management of such bypass areas. This also means that the non-current-contributing area II can withstand more current for the same surface area. The current flow and thus the heating, especially at the edges, is distributed over a greater edge length, so that a smaller size is sufficient to carry the same current. The additional P1 structures further enhance this effect.

Fig. 3 shows a schematic illustration of embodiments of structured serial connected optoelectronic cells 1 each comprising a current-contributing area I and a non-current-contributing area II in plan view and in cross-sectional view. The direction of current flow in the embodiment shown in Fig. 3 is from the left-hand side to the right-hand side.

The embodiment of Fig. 3A mainly corresponds to the embodiment of Fig. 2A, the embodiment of Fig. 3B mainly corresponds to the embodiment of Fig. 2B, and the embodiment of Fig. 3C mainly corresponds to the embodiment of Fig. 2C, so that reference is made to this in each case.

In Fig. 3A, 3B and 3C cross section along A-A demonstrates the structured stack 10 within the non-current-contributing area II; cross-section along B-B demonstrates the structured stack 10 within the current-contributing area I; and cross-section along C-C demonstrates the structured stack 10 through an additional P2 structure within the non-current-contributing area II. P1 structures electrically separate the base electrode 11 of the current-contributing area I from the base electrode 11 of the at least one non-current-contributing area II of the optoelectronic cell 1 and from the base electrodes 11 of neighboring optoelectronic cells 1. P2 structures electrically separate the photoactive layer 13 in the current-contributing area I from the photoactive layer 13 in the current-contributing area I of a neighboring optoelectronic cell 1, while additional P2 structures are formed within the at least one non-current-contributing area II in parallel at least partly along each of the three edges 15 between the P3 structures and the P1 structures. In this embodiment, the P2 structures are filled with material of the top electrode 12. P3 structures electrically separate the top electrode 12 of the current-contributing area I from the top electrode 12 of the non-current-contributing area II of the optoelectronic cell 1, from the top electrode 12 of the current-contributing area I and the non-current-contributing area II of a preceding optoelectronic cell 1 in the direction of current flow. Additionally, the area restricted by the three edges 15 within the non-current-contributing area II is separated by P3 structures from the non-current-contributing area II of a following optoelectronic cell 1 in the direction of current flow. The top electrode 12 of the non-current-contributing area II of an optoelectronic cell 1 is electrically connected to the top electrode 12 of the preceding optoelectronic cell 1 in the direction of current flow. The top electrode 12 of the current-contributing area I of an optoelectronic cell 1 is electrically connected to the base electrode 11 of the current-contributing area I of a following optoelectronic cell 1 in the direction of current flow.

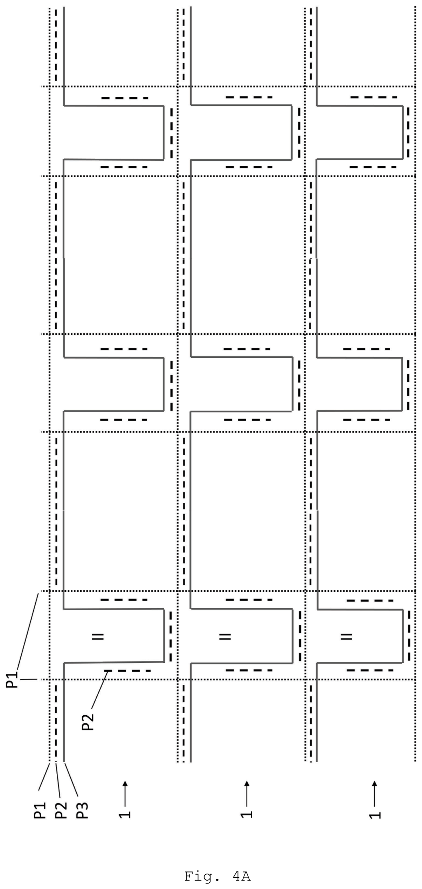

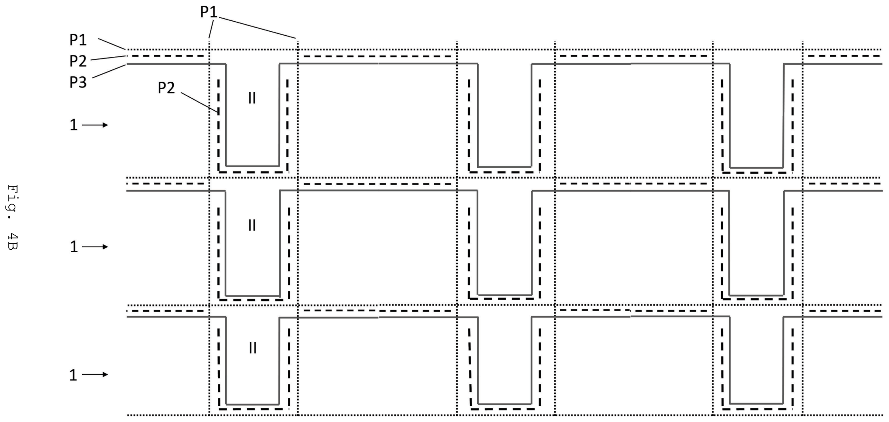

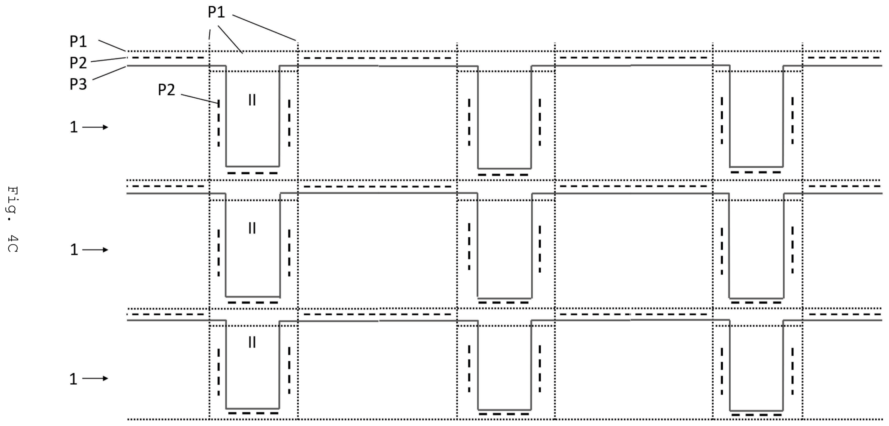

Fig. 4 shows a schematic illustration of embodiments of photovoltaic elements 100 comprising optoelectronic cells 1 having several non-current-contributing areas II in plan view. In this exemplary embodiment, the photovoltaic elements 100 each comprises three optoelectronic cells 1 which are connected in series. Each optoelectronic cell 1 comprises three non-current-contributing areas II having current-contributing areas I in between. The non-current-contributing areas II are arranged in a certain distance to each other extending in transverse direction of the optoelectronic cell 1.

The embodiment of Fig. 4A mainly corresponds to the embodiment of Fig. 2A, the embodiment of Fig. 4B mainly corresponds to the embodiment of Fig. 2B, and the embodiment of Fig. 4C mainly corresponds to the embodiment of Fig. 2C, so that reference is made to this in each case.

Furthermore, each optoelectronic cell 1 has a continuous separating structure of the third type P3 extending along the longitudinal direction of the optoelectronic cell 1, wherein the separating structure of the third type P3 forms a bulge in the at least one non-current-contributing area II in the direction of current flow. In this embodiment the bulge has rectangular shape.

In one configuration of the invention, a surface area of the surface in the main extension plane of the at least one non-current-contributing area II of the optoelectronic cell 1 is 2% to 10% of total surface area of the surface in the main extension plane of the optoelectronic cell 1.

## Claims

1. Photovoltaic element (100) having at least two optoelectronic cells (1), the at least two optoelectronic cells (1) being connected in series, each optoelectronic cell (1) having a stack (10) comprising a base electrode (11), a top electrode (12), a photoactive layer (13) arranged between the base electrode (11) and the top electrode (12), structures of a first type (P1 structures) which electrically separate the base electrode (11), structures of a second type (P2 structures) which electrically separate the photoactive layer (13), and structures of a third type (P3 structures) which electrically separate the top electrode (12), wherein each optoelectronic cell (1) comprises a current-contributing area (I) and at least one non-current-contributing area (II) which share the same stack (10), wherein the at least one non-current-contributing area (II) is arranged within the current-contributing area (I) extending to a following optoelectronic cell (1) in the direction of current flow and delimited from the current-contributing area (I) by separating structures, wherein the current-contributing area (I) and the at least one non-current-contributing area (II) of the optoelectronic cell (1) are electrically connected antiparallel to each other, wherein the stack (10) of each optoelectronic cell (1) is structured by P1 structures between the current-contributing area (I) and the at least one non-current-contributing area (II), and the base electrode (11) of the at least one non-current-contributing area (II) is electrically connected to the top electrode (12) of the current-contributing area (I), wherein the at least one non-current-contributing area (II) is delimited by P3 structures from the current-contributing area (I) of the optoelectronic cell (1) and the at least one non-current-contributing area (II) of the following optoelectronic cell (1) in the direction of current flow forming three edges (15), and wherein additional P2 structures are formed within the at least one non-current-contributing area (II) in parallel at least partly along each of the three edges (15) between the P3 structures and the P1 structures.

2. Photovoltaic element (100) according to claim 1, wherein P1 structures electrically separate the base electrode (11) of the current-contributing area (I) and of the at least one non-current-contributing area (II) of neighboring optoelectronic cells (1).

3. Photovoltaic element (100) according to claim 1 or 2, wherein P1 structures between the current-contributing area (I) and the at least one non-current-contributing area (II) of the optoelectronic cell (1) and between neighboring optoelectronic cells (1), P2 structures between the current-contributing area (I) of the optoelectronic cell (1) and the current-contributing area (I) of neighboring optoelectronic cells (1), and P3 structures between the current-contributing area (I) and the non-current-contributing area (II) of the optoelectronic cell (1) and the current-contributing area (I) of a neighboring optoelectronic cell (1) are formed.

4. Photovoltaic element (100) according to any one of the preceding claims, wherein the non-current-contributing area (II) of each optoelectronic cell (1) extends over the entire distance of each optoelectronic cell (1) in transverse direction.

5. Photovoltaic element (100) according to any one of the preceding claims, wherein the additional P2 structures along each of the three edges (15) extend along an entire length of the three edges (15) between the P3 structures and the P1 structures of the non-current-contributing area (II).

6. Photovoltaic element (100) according to any one of the preceding claims, wherein a distance between the additional P2 structures along each of the three edges (15) to the corresponding edge (15) in horizontal direction is in the range of 50 µm to 2 mm, preferably in the range of 100 µm to 500 µm.

7. Photovoltaic element (100) according to any one of the preceding claims, wherein the top electrode (12) of the current-contributing area (I) of an optoelectronic cell (1) is electrically connected to the base electrode (11) of the current-contributing area (I) of the following optoelectronic cell (1) in the direction of current flow.

8. Photovoltaic element (100) according to any one of the preceding claims, wherein the top electrode (12) of the at least one non-current-contributing area (II) is electrically connected to the base electrode (11) of the current-contributing area (I) of the corresponding optoelectronic cell (1).

9. Photovoltaic element (100) according to any one of the preceding claims, wherein the base electrode (11) of the at least one non-current-contributing area (II) of the optoelectronic cell (1) is electrically connected to the top electrode (12) of an adjacent current-contributing area (I) of the same optoelectronic cell (1).

10. Photovoltaic element (100) according to any one of the preceding claims, wherein each optoelectronic cell (1) comprises at least two non-current-contributing areas (II), preferably comprises two non-current-contributing areas (II) in a certain distance to each other extending in transverse direction of the optoelectronic cell (1).

11. Photovoltaic element (100) according to any one of the preceding claims, wherein the P3 structures of the optoelectronic cell (1) are continuously extending along the longitudinal direction of the optoelectronic cell (1), wherein the P3 structures are separating the current-contributing-area (I) of the optoelectronic cell (1) from the current-contributing-area (I) of a preceding optoelectronic cell (1) in the direction of current flow and separating the non-current-contributing area (II) of the optoelectronic cell (1) from the non-current-contributing area (II) of the following optoelectronic cell (1) in the direction of current flow.

12. Photovoltaic element (100) according to any one of the preceding claims, wherein the three edges (15) of the P3 structures of the optoelectronic cell (1) are arranged at right angles directly to each other and are arranged at right angles directly to the P3 structures separating the current-contributing-area (I) of the optoelectronic cell (1) from the current-contributing-area (I) of a preceding optoelectronic cell (1) in the direction of current flow.

13. Photovoltaic element (100) according to any one of the preceding claims, wherein an additional P1 structure is formed in the non-current-contributing area (II), preferably parallel to the P1 structures to the preceding optoelectronic cell (1) in the direction of current flow, wherein the additional P1 structure separates the base electrode (11) of the non-current-contributing area (II) at a region where the three edges (15) of the at least one non-current-contributing area (II), in particular the two edges (15) separating from the current-contributing area (I) of the optoelectronic cell (1), meet the remaining P3 structures of the optoelectronic cell (1) at a side facing away from the preceding optoelectronic cell (1) in the direction of current flow.

14. Photovoltaic element (100) according to claim 13, wherein the additional P1 structure is formed at the two edges (15) which separate from the current-contributing area (I) of the optoelectronic cell (1) at a side of the edges (15) facing the remaining P3 structures.

15. Photovoltaic element (100) according to any one of the preceding claims, wherein an extension of the at least one non-current-contributing area (II) in transverse direction is at least twice as large as in longitudinal direction of the optoelectronic cell (1), preferably at least three times, or preferably at least four times.
